Europäisches Patentamt

European Patent Office

Office européen des brevets

(11) Veröffentlichungsnummer: **0 115 352**
**A2**

(12) # EUROPÄISCHE PATENTANMELDUNG

(21) Anmeldenummer: **84100923.6**

(22) Anmeldetag: **30.01.84**

(51) Int. Cl.³: **H 03 K 13/05**

(30) Priorität: **31.01.83 DE 3303117**

(43) Veröffentlichungstag der Anmeldung:
**08.08.84 Patentblatt 84/32**

(84) Benannte Vertragsstaaten:
**AT DE FR GB IT SE**

(71) Anmelder: SIEMENS AKTIENGESELLSCHAFT
Berlin und München Wittelsbacherplatz 2
D-8000 München 2(DE)

(72) Erfinder: Petschacher, Reinhard, Dipl.-Ing.
Aufeldgasse 13
A-9500 Villach(AT)

(72) Erfinder: Luschnig, Werner, Dipl.-Ing.
Rudolfweg 32
A-9524 St. Magdalen(AT)

(54) **Integrierbarer Digital/Analog-Wandler.**

(57) Die Erfindung betrifft einen nach dem Parallelverfahren arbeitenden D/A-Wandler, dessen jeweils einer Bitwertigkeit des auszuwertenden Digitalwortes zugeordnete Wandlerstufen in üblicher Weise jeweils eine einen gewichteten Konstantstrom liefernde Stromquelle und einen deren Ausgang auf den gemeinsamen Ausgang des Wandlers legenden und nach Maßgabe des dieser Stufe zugeordneten Steuerbits gesteuerten Umschalter aufweisen. Um die bei den üblichen D/A-Wandlern dieser Art auftretenden und durch unterschiedliche Ansprechgeschwindigkeitder einzelnen Umschalter bedingten Fehler im Ausgangssignal zu unterbinden wird gemäß der Erfindung die einzelne Umschaltstufe durch ein Differenzsignal angesteuert, wobei der Schaltzeitpunkt für die ansteigende Flanke und die absteigende Flanke unterschiedlich eingestellt ist. Die Quelle für das Differenzsignal besteht aus einem ECL-Flip-Flop mit einer weiteren Differenzstufe, die mit denselben Lastwiderständen wie das Flip-Flop arbeitet, wobei ein zusätzlicher Gleichstrom in das Differenzsignal eingeprägt wird.

FIG 1

EP 0 115 352 A2

SIEMENS AKTIENGESELLSCHAFT
Berlin und München

Unser Zeichen
VPA 83 P 5301 E

0115352

## Integrierte Digital/Analog-Wandler

Die Erfindung bezieht sich auf einen integrierbaren Digital/Analog-Wandler mit einem durch das umzuwandelnde Digitalsignal zu beaufschlagenden Signaleingang und einem das aufgrund der Umwandlung entstehende Analogsignal liefernden Signalausgang, bei der jedes Bit des digitalen Eingangssignals zur Steuerung je eines Umschalters für je einen Konstantstrom vorgesehen ist, bei der diese von jeweils einer Konstantstromquelle gelieferten Konstantströme derart binär gewichtet sind, daß die Wertigkeit der über die einzelnen Umschalter geführten Konstantströme jeweils der Bitwertigkeit des zur Steuerung des betreffenden Umschalters jeweils vorgesehenen Bits in dem umzuwandelnden Digitalsignal entspricht, bei der ferner jeder dieser - einander gleichen - Umschalter durch je einen Differenzverstärker gegeben ist, bei dem die ihn bildenden und mit ihren Stromeingangselektroden zusammen durch die jeweils zugeordnete Konstantstromquelle beaufschlagten und einander gleichen Transistoren an ihren Steuerelektroden aufgrund des jeweils auszuwertenden Bits derart gesteuert sind, daß bei einem dem Zustand logisch "1" entsprechenden Steuerbit der von der betreffenden Konstantstromquelle gelieferte Konstantstrom bei allen diesen Umschaltern an einen gemeinsamen und für das zu erzeugende Analogsignal zuständigen Signalausgang geschaltet wird, während bei einem dem Zustand logisch "0" entsprechenden Steuerbit der Konstantstrom stattdessen an einen anderen gemeinsamen Signalausgang oder an den Fußpunkt der betreffenden Konstantstromquelle gelegt wird.

Stg 1 Kth / 25.01.1983

Bei üblichen Digital/Analog-Wandlern dieser Art kann man bei einer ersten Ausführungsform die Wichtung der einzelnen Konstantströme durch entsprechende Bemessung der sie erzeugenden und durch je einen Transistor, insbesondere in Stromspiegelschaltung, realisierten Konstantstromquelle erreichen. Bei einer bekannten Möglichkeit dieser Art ist der durch das LSB gesteuerte Umschalter an eine Konstantstromquelle gelegt, die durch einen Transistor mit einem Emitter gegeben ist, wobei der Emitter am Bezugspotential und die Basis an einem für alle diese Konstantstromquellen gemeinsamen Steuerpotential liegt. Dem durch das Bit mit der nächstniedrigen Wertigkeit gesteuerten Umschalter ist dann ein Transistor mit zwei Emittern zugeordnet, der den doppelten Strom im Vergleich zur ersten Stromquelle liefert. Das Bit mit der nächsten Wertigkeit, der ein Konstantstrom des vierfachen Wertes zugeordnet ist, hat dann einen Transistor mit vier Emittern usw. als Sonstantstromquelle. Man kann natürlich auch eine der Wichtung entsprechende Anzahl von einander gleichen Transistoren zu einander parallel schalten, die dann an ihrem gemeinsamen Ausgang den gewichteten Strom liefern. Dieses Vorgehen ist vor allem dann von $I_n$teresse, wenn es sich um eine mittels insbesondere einander gleichen MOS-Feldeffekttransistoren vom Anreicherungstyp ausgebildete Schaltung des D/A-Wandlers handelt.

Andererseits kann man aber auch für die Beaufschlagung der einzelnen Umschalter je eine Konstantstromquelle verwenden, die an sich denselben Strom wie die übrigen Konstantstromquellen abgibt. Die Wichtung wird dann durch ein entsprechendes Widerstandsnetzwerk erreicht, das die von den einzelnen Konstantstromquellen über den jeweils zugeordneten Umschalter gelieferten Konstantstrom auf unterschiedliche Weise mit dem gemeinsamen Ausgang verbindet und auf diese Weise die angestrebte Wichtung erreicht.

Zusammenfassend kann also festgestellt werden, daß man bei den der oben gegebenen Definition entsprechenden Digital/Analog-Wandlern gewichtete Ströme je nach Eingangsdaten (also dem umzuwandelnden Digitalsignal) an den das gewünschte Analogsignal liefernden Ausgang hinzu- oder weggeschaltet. Dabei hat sich aber gezeigt, daß durch ungleichzeitige Betätigung der jeweils zu betätigenden Umschalter unbeabsichtigter Weise Stromspitzen bzw. Stromeinbrüche entstehen, die das abgegebene Signal ggf. verfälschen können. Diese Erscheinung wird als GLITCH-Effekt bezeichnet. Man kann nun diese Erscheinung durch ein ausgewogenes Layout der den D/A-Wandler darstellenden integrierten Schaltung vermindern aber nicht völlig beseitigen. Hier soll die Erfindung eine Abhilfe schaffen.

Erfindungsgemäß ist vorgesehen, daß bei jedem der die gewichteten Konstantströme führenden Umschalter ($U_i$; i = 1,2.......) jeweils eine Kombination aus sechs einander gleichen Transistoren zugeordnet ist und dabei ein erster Transistor und ein zweiter Transistor durch Kreuzkopplung zu einem RS-Flip-Flop vereinigt sind, daß außerdem die Stromausgangselektrode der beiden das Flip-Flop bildenden Transistoren jeweils über einen Lastwiderstand mit dem das erste Versorgungspotential liefernden Versorgungsanschluß und außerdem mit der Stromausgangselektrode jeweils zweier weiterer dieser Transistoren verbunden ist, daß dabei die Stromeingangselektrode der beiden das Flip-Flop bildenen Transistoren gemeinsam durch ein erstes Strobesignal und die Stromeingangselektrode je eines der beiden über ihre Stromausgangselektrode mit je einem der beiden Signalanschlüsse des Flip-Flops verbundenen Transistoren durch ein gemeinsames zweites Strobesignal beaufschlagt und die Steuerelektrode des einen der beiden zuletzt genannten Transistoren durch das dem betreffenden Umformer jeweils zugeordnete Bit des auszuwertenden Digitalsignals gesteuert, sowie die Steuerelektrode des anderen dieser beiden Transistoren durch eine auf das von einem weiteren Versorgungsanschluß gelieferte Bezugspotential bezogene Referenzspannung beaufschlagt ist, daß weiterhin die Steuerelektrode der beiden letzten und mit je einem der beiden Signalanschlüsse des Flip-Flops verbundenen Transistoren jeweils durch eine weitere Referenzspannung beaufschlagt ist, während ihre Stromeingangselektrode-insbesondere Vermittlung je eines Widerstandes-an den Ausgang einer gemeinsamen Stromquelle gelegt ist, deren Fußpunkt durch den Versorgungsanschluß für das Bezugspotential gegeben ist, und daß schließlich die beiden Signalausgänge jeweils an einen der beiden Steuereingänge des zugehörigen Umschalters derart gelegt ist, daß nur bei einer Bitwertigkeit "1" für das den Umschalter über das Flip-Flop steuernden Bits der über den Umschalter geführte Konstantstrom an den das zu erzeugende Analogsignal liefernden gemeinsamen Ausgang gelangt.

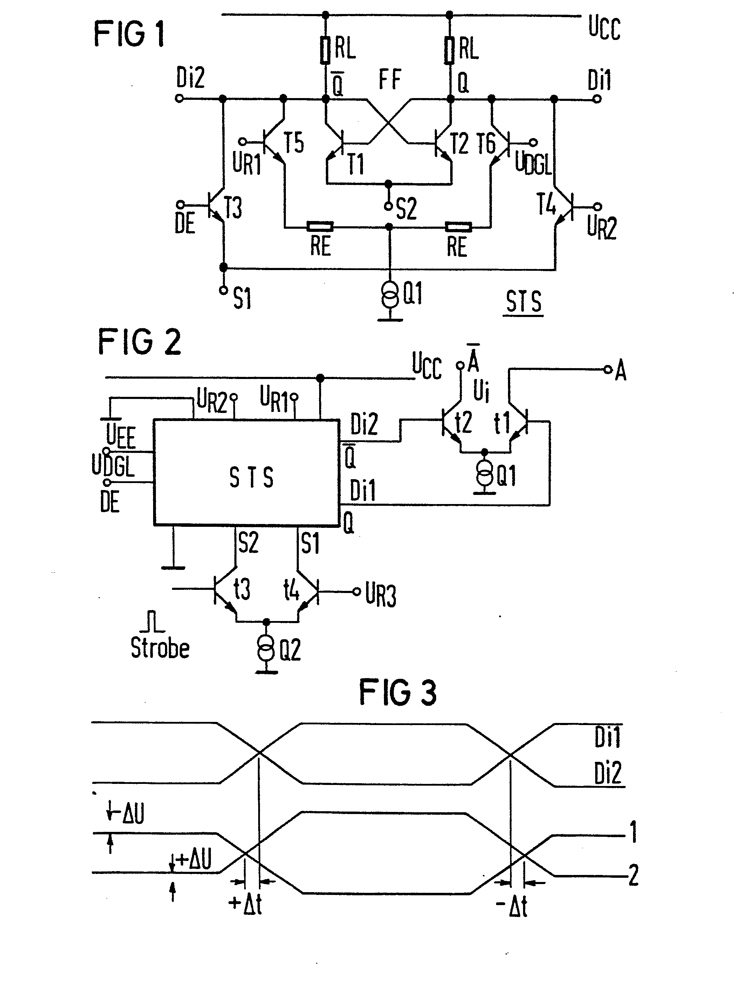

Die Erfindung wird nun anhand der Figuren 1 und 2 näher beschrieben. Dabei stellt Fig. 1 die aus den genannten sechs Transistoren bestehende Kombination zur Beaufschlagung des einzelnen Umschalters und Fig. 2 dessen Verbindung mit einem üblichen Umschalter als auch weitere Einzelheiten hinsichtlich der benötigten Strobe-signale dar. Fig. 3 bringt schließlich noch das zugehörige Zeitdiagramm.

Die in Fig. 1 und Fig. 2 dargestellte Ausführungsform der Erfindung verwendet als Transistoren ausschließlich bipolare npn-Transistoren. Man kann verständlicherweise die npn-Transistoren auch durch pnp-Transistoren ersetzen. Eine andere Möglichkeit ist die Verwendung von Feldeffekttransistoren, insbesondere von sebstsprerrenden MOS-Feldeffekttransistoren.

Das in der obigen Definition der Erfindung genannte und in der ECL-Technik übliche Flip-Flop FF besteht aus den beiden npn-Transistoren T1 und T2, wobei die Emitter der beiden Transistoren unmittelbar miteinander verbunden sind, während die Basis des jeweils einen der beiden Transistoren T1 und T2 jeweils mit dem Kollektor des anderen Transistors T2 und T1 unmittelbar leitend verbunden ist. Der Emitter ist gemäß der obigen Definition die Stromeingangselektrode, der Kollektor die Stromausgangselektrode und die Basis bzw. deren Anschluß, die Steuerelektrode. Bei Verwendung von Feldeffekttransistoren ist der Sourceanschluß die Stromeingangselektrode, der Drainanschluß die Stromausgangselektrode und das Gate die Steuerelektrode.

Bei dem in Figur 1 gezeichneten Beispielsfall ist der Kollektor des ersten Transistors T1 zugleich der $\bar{Q}$-Ausgang und der Kollektor des zweiten Transistors T2 zugleich der Q-Ausgang des RS-Flip-Flops FF. Beide Ausgänge sind über je einen Lastwiderstand RL mit dem Versorgungsanschluß für das erste Versorgungspotential $U_{CC}$ verbunden. Der nichtinvertierende Ausgang Q liefert ein Signal Di1 und der invertierende Ausgang $\bar{Q}$ ein zum Signal Di1 invertiertes Signal Di2. Diese beiden Signale werden in der aus Figur 2 ersichtlichen Weise zur Steuerung des zugehörigen Umschalters $U_i$ verwendet.

Das den betreffenden Umschalter steuernde Bit des auszuwertenden Digitalsignals liegt am Dateneingang DE, der durch die Basis eines weiteren npn-Transistors T3 gegeben ist. Der Kollektor dieses npn-Transistors ist unmittelbar mit dem Kollektor des ersten npn-Transistors T1 und damit mit dem invertierenden Ausgang $\bar{Q}$ des Flip-Flops FF verbunden. Ein dem Transistor T3 entsprechender weiterer npn-Transistor T4 ist an seiner Basis durch Referenzspannung $U_{R2}$ (bezogen auf das Bezugspotential (Masse)) beaufschlagt und ist mit seinem Kollektor unmittelbar mit dem Kollektor des zweiten Transistors T2 des RS-Flip-Flops und damit mit dem nichtinvertierenden Signalausgang Q des Flip-Flops verbunden. Die Emitter des dritten Transistors T3 und des vierten Transistors T4 liegen gemeinsam an einem ersten Strobesignal S1. Ein zweites Strobesignal S2 das zu dem ersten Strobesignal invertiert ist, dient zur Beaufschlagung der Emitter der beiden das Flip-Flop FF bildenden Transistoren T1 und T2. Ein fünfter npn-Transistor T5 ist mit seinem Kollektor ebenfalls unmittelbar an den invertierenden Ausgang $\bar{Q}$ des Flip-Flops FF und ihm entsprechend ein sechster npn-Transistor T6 mit seinem Kollektor an den das nichtinvertierte Signal liefernden Ausgang Q des besagten Flip-Flops FF gelegt. Beide Transistoren T5 und T6 liegen über je einen Emitterwiderstand RE am stromliefernden Ausgang einer gemeinsamen Konstantstromquelle Q1, die mit ihrem Fußpunkt am Bezugspotential $U_{EE}$ liegt. Die Konstantstromquelle Q1 gehört nicht zu den mit den einzelnen Umformern U1, U2, .... verbundenen Konstantstromquellen. Sie ist in üblicher Weise durch einen Transistor, z.B. in Stromspiegelschaltung gegeben, dessen Emitter mit dem Versorgungsanschluß für das Bezugspotential $U_{EE}$ und dessen Kollektor über die beiden Widerstände RE an je einen der beiden Transistoren T5 und T6 gelegt ist, wie bereits oben dargelegt wurde.

Schließlich ist noch zu bemerken, daß die Basis des am Ausgang $\bar{Q}$ des Flip-Flops FF liegenden Transistors T5 durch eine Referenzspannung $U_{R1}$ und die Basis des Transistors T6 durch eine einstellbare Spannung $U_{DGL}$ (bezogen auf das Bezugspotential $U_{EE}$) beaufschlagt ist.

Angestrebt ist durch die Erfindung, daß jeder der vorgesehenen Umschalter $U_i$ (i = 1, 2, ...) von einem Differenzsignal Di1 bzw. Di2 angesteuert wird, wie dies aus Figur 2 ersichtlich ist. Dabei soll das unterschiedliche und den GLITCH-Effekt bedingende Schaltverhalten der einzelnen Umschalter kompensiert werden, indem der Schaltzeitpunkt für die ansteigende und die abfallende Flanke der im Zeitdiagramm gemäß Figur 3 ersichtlichen Differenzsignale Di1, Di2 unterschiedlich eingestellt wird. Der Schaltzeitpunkt ist durch den Kreuzungspunkt der beiden Signale Di1 und Di2 (d.h. durch den Zeitpunkt, wenn beide Potentiale Di1 und Di2 denselben Wert haben) gegeben. Während bei dem aus Figur 3a ersichtlichen Diagramm beide Signale bezüglich ihrer zeitlichen Ableitung in jedem Zeitpunkt einander gleich sind, wird gemäß Fig. 3b aufgrund der Erfindung eine zeitliche Versetzung des Kreuzungspunkts gegenüber dem Fall gemäß Figur 3a durch eine von außen angelegte Spannung $U_{DGL}$ zeitlich so versetzt, daß er beim Einschalten (=schnellerer Vorgang) um die Zeitspanne $\Delta t$ später und beim Ausschalten um dieselbe Zeispanne $\Delta t$ früher kommt. Dies wird durch eine Umverteilung des Gleichspannungsanteils um den Wert $\Delta U$ der beiden Differenzsignalpotentiale Di1 und Di2 erreicht. (vgl. Fig. 3b).

Die dieses Verhalten sicherstellende Schaltung gemäß Figur 1 verwendet als Quelle für das Differenzsignal Di1 und Di2 ein ECL-Flip-Flop FF. Dabei wird über eine weitere Differenzstufe, die aus den beiden Transistoren T5 und T6 gebildet ist, und die an denselben Lastwiderständen 'RL wie das Flip-Flop FF arbeitet, ein zusätzlicher Gleichstrom eingeprägt. Wird dieser Gleichstrom unsymmetrisch verteilt, so verschieben sich die Pegel der Differenzsignale Di1 und Di2 in entgegengesetzter Richtung. Die Verteilung dieses Gleichstroms kann kontinuierlich durch Veränderung von $U_{DGL}$ eingestellt werden. Um die Empfindlichkeit dieser Einstellung herabzusetzen, können zusätzliche Emitterwiderstände RE vorgesehen sein.

Das das umzuwandelnde Digitalsignal bildende digitale
Datenwort wird zweckmäßig parallel zunächst in einen
Speicher eingegeben, in welchem eine Anzahl aufeinander
folgender Speicherzellen an ihrem Datenausgang mit je
einer Schaltung gemäß Fig. 1 über deren Dateneingang
DE, also der Basis des Transistors T3, verbunden ist.
Dabei ist darauf geachtet, daß die Bitwertigkeit i des
den Dateneingang DE steuernden Bits des auszuwertenden
Digitalsignals mit der aufgrund der Wichtung erhaltenen
Wertigkeit des über den durch die jeweils betrachtete
Schaltung STS gemäß Fig. 1 gesteuerten Umschalters $U_i$
übereinstimmt. Die aus Fig. 2 ersichtliche Ansteuerung
des aus den beiden npn-Transistoren t1 und t2 gebildeten Umschalters $U_i$ durch die von den beiden Signalausgängen Q bzw. $\overline{Q}$ des Flip-Flops FF ist so getroffen,
daß der von der Konstantstromquelle $Q_i$ über den durch
den von den beiden Transistoren t1,t2 gebildeten Differenzverstärker gegebenen Umschalter $U_i$ geführte Konstantstrom hinsichtlich seiner Wichtung der Bitwertigkeit des am Eingang DE jeweils angelegten Bits in dem
auszuwertenden Digitalsignal entspricht. Dabei ist vor
allem       entsprechend der Definition der Erfindung
darauf geachtet, daß das dem logischen Zustand des jeweils am Eingang DE anhängigen Datenbits entsprechende
Differenzsignal Di1 den Transistor T1 steuert, dessen
Kollektor zu dem für das zu erzeugende Analogsignal vorgesehenen gemeinsamen Signalausgang A führt. Bei dem in
Fig. 2 dargestellten Beispielfall führt der andere Transistor t2 des Umschalters $U_i$ zu einem invertierten Aus-
$\overline{A}$. Der Transistor t2 wird durch das Differenzsignal Di2
gesteuert, welches in seinem logischen Zustand dem invertierten Steuerbit entspricht. Der Ausgang $\overline{A}$ ist

ebenfalls für alle diese Umschalter $U_i$ gemeinsam und kann z.B. durch den Anschluß für das Bezugspotential $U_{EE}$ gegeben sein.

Zur Erzeugung der beiden Strobesignale S1 und S2 ist ein durch die beiden npn-Transistoren t3 und t4 sowie einer Konstantstromquelle Q2 in der aus Fig. 2 ersichtlichen Weise gebildeter weiterer Differenzverstärker vorgesehen, Dabei ist der eine Transistor, dessen Kollektor das Strobesignal S2 für die Steuerung der beiden Transistoren T3 und T4 liefert, durch ein mit "Strobe" bezeichnetes Taktsignal und der andere Transistor t4 durch eine dritte Referenzspannung $U_{R3}$ gesteuert. Dieser liefert das zur Beaufschlagung der Emitteranschlüsse der das Flip-Flop FF bildenden Transistoren T1,T2 dienende erste Strobesignal S1.

Die zur Beaufschlagung des die beiden Strobesignale S1 und S2 liefernden Differenzverstärkers t3,t4 vorgesehene und dessen Verbindung zum Bezugspotential $U_{EE}$ bildende Konstantstromquelle Q2 entspricht in ihrem Eigenschaften der Konstantstromquelle Q1 in Fig. 1 (die somit einen Bestandteil dieses in Fig. 2 lediglich als Block STS dargestellten Schaltungsteile STS bildet).

Hinsichtlich der Bemessung der Referenzspannung, die zur Steuerung der Transistoren T4, T5, T6 und t4 vorgesehen sind, ist noch folgendes zu bemerken.

a) die zur Steuerung des Transistors T6 vorgesehene Referenzspannung $U_{DGL}$ wird zweckmäßig extern, z.B. mittels eines Potentiometers, eingestellt und entsprechend den oben angegebenen Gesichtspunkten bemessen.

b) Die zur Steuerung des Transistors T5 dienende Referenzspannung $U_{R1}$ wird intern durch einen Spannungsteiler erzeugt.

0115352

c) Die zur Steuerung des Transistors T4 vorgesehene Referenzspannung $U_{R2}$ wird aus einer ECL-Referenzspannung (üblicherweise - 1.29 V) durch Abzug des Spannungsabfalls an einer Diode gewonnen.

d) Die zur Erzeugung des ersten Strobesignals S1 vorgesehene Referenzspannung $U_{R3}$ wird so eingestellt, daß sie wie oben um den Spannungsabfall an einer Diode negativer ist als $U_{R3}$.

Zu bemerken ist schließlich, daß die in Figur 1 und in Figur 2 dargestellte Schaltung sich auch durch andere Transistoren realisieren läßt. Da man D/A-Wandler der eingangs gegebenen Definition auch in Ein-Kanal MOS-Technik herstellen kann (wie bereits eingangs angedeutet) kann es zweckmäßig sein, auch die erfindungsgemäße Schaltung in der entsprechenden MOS-Technik zu realisieren, wobei die Transistoren dann zweckmäßig durch denselben Kanaltyp aufweisende MOS-FET's vom Anreicherungstyp gegeben sind.

3 Figuren
6 Patentansprüche

0115352

Patentansprüche

1. Integrierbarer Digital/Analog-Wandler mit einem durch das umzuwandelnde Digitalsignal zu beaufschlagenden Signaleingang und einem das aufgrund der Umwandlung entstehende Analogsignal liefernden Signalausgang, bei der jedes Bit des digitalen Eingangssignals zur Steuerung je eines Umschalters für je einen Konstantstrom vorgesehen ist, bei der diese von jeweils einer Konstantstromquelle gelieferten Konstantströme derart binär gewichtet sind, daß die Wertigkeit der über den einzelnen Umschalter geführten Konstantströme jeweils der Bitwertigkeit des zur Steuerung des betreffenden Umschalters jeweils vorgesehenen Bits in dem umzuwandelnden Digitalsignal entspricht, bei der ferner jeder dieser - einander gleichen - Umschalter durch je einen Differenzverstärker gegeben ist, bei dem die ihn bildenden und mit ihren Stromeingangselektroden zusammen durch die jeweils zugeordnete Konstantstromquelle beaufschlägten und einander gleichen Transistoren an ihren Steuerelektroden aufgrund des jeweils auszuwertenden Bits derart gesteuert sind, daß bei einem dem Zustand logisch "1" entsprechenden Steuerbit der von der betreffenden Konstantstromquelle gelieferte Konstantstrom bei allen diesen Umschaltern an einen gemeinsamen und für das zu erzeugende Analogsignal zuständigen Signalausgang geschaltet wird, während bei einem dem Zustand logisch "0" entsprechenden Steuerbit der Konstantstrom stattdessen an einen anderen gemeinsamen Signalausgang oder an den Fußpunkt (=Massepunkt) der betreffenden Konstantstromquelle gelegt wird, d a d u r c h g e k e n n z e i c h n e t , daß jedem der die gewichteten Konstantströme führenden Umschalter ($U_i$) jeweils eine Kombination aus sechs einander gleichen Transistoren (T1, T2, T3, T4, T5, T6) zugeordnet ist und dabei ein erster und ein zweiter Transistor (T1,T2) durch Kreuzkopplung zu einem RS-Flip-Flop (FF) vereinigt sind, daß außerdem die Stromausgangselektrode der beiden das Flip-Flop (FF) bildenden Transistoren (T1, T2) über je einen Lastwiderstand (RL) mit dem das erste Versorgungspotential ($U_{CC}$) liefernden Versorgungsanschluß und außerdem mit der Stromausgangselektrode jeweils zweier weiterer dieser Transistoren (T3,T5 bzw. T4, T6) verbunden ist, daß dabei die Stromeingangselektode der beiden das Flip-Flop (FF) bildenden Transistoren (T1,T2) gemeinsam durch ein erstes Strobesignal (S1) und die Stromeingangselektrode je eines der beiden über ihre Stromausgangselektrode mit je einem der beiden Signalanschlüsse (Q, $\bar{Q}$) des Flip-Flops (FF) verbundenen Transistoren (T3, T4) durch ein gemeinsames weiteres Strobesignal (S2) beaufschlagt und die Steuerelektrode des einen der beiden zuletzt genannten Transistoren (T3) durch das dem betreffenden Umformer ($U_i$) jeweils zugeordnete Bit des auszuwertenden Digitalsignals gesteuert sowie die Steuerelektrode des anderen dieser beiden Transistoren (T4) durch eine auf das von einem weiteren Versorgungsanschluß gelieferte Bezugspotential ($U_{EE}$) bezogene Referenzspannung ($U_{R2}$) beaufschlagt ist, daß weiterhin die Steuerelektrode der beiden letzten der mit je einem der beiden Signalanschlüsse (Q, $\bar{Q}$) des Flip-Flops (FF) verbundenen Transistoren (T5,T6) - insbesondere unter Vermittlung je eines Widerstandes (RE)-an den Ausgang einer gemeinsamen Stromquelle (Q1) gelegt und deren Fußpunkt durch den Versorgungsanschluß für das Bezugspotential ($U_{EE}$) gegeben ist, und daß schließlich die beiden Signalausgänge (Q, $\bar{Q}$) des Flip-Flops jeweils an einen der beiden Steuereingänge des zugehörigen Umschalters ($U_i$) derart gelegt sind, daß nur bei einer Bitwertigkeit "1" für das den Umschalter ($U_i$) über das Flip-Flop (FF) steuernde Bit der über den Umschalter ($U_i$) geführte Konstantstrom an den das zu erzeugende Analogsignal liefernden gemeinsamen Ausgang gelangt.

2. Digital/Analog-Wandler nach Anspruch 1, d a -
d u r c h   g e k e n n z e i c h n e t, daß die
Steuerelektroden der beiden durch die Verbindung ihrer
Stromeingangselektroden mit dem Ausgang einer Konstantstromquelle (Q1) zu einem Differenzverstärker vereinigten
Transistoren (T5,T6) derart beaufschlagt sind, daß der
mit seiner Stromausgangselektrode am invertierenden
Ausgang ($\overline{Q}$) und damit an der Stromausgangselektrode
des durch das Steuerbit beaufschlagten Transistors (T3)
liegende dieser beiden Transistoren (T5) durch eine
extern einzustellende Steuergleichspannung ($U_{DGL}$)und
der andere durch eine feste Referenzspannung ($U_{R2}$)
gesteuert ist.

3. Digital/Analog-Wandler nach Anspruch 1 oder 2,
d a d u r c h   g e k e n n z e i c h n e t, daß
die beiden Strobesignale (S1,S2) zueinander invertiert
sind.

4. Digital/Analog-Wandler nach Anspruch 3, d a -
d u r c h   g e k e n n z e i c h n e t, daß zur
Erzeugung der beiden Strobesignale (S1, S2) ein aus
zwei mit ihren Stromeingangselektroden miteinander
verbundenen Transistoren (t3,t4) und über eine Stromquelle (Q2) an das Bezugspotential ($U_{EE}$) angeschlossener
Differenzverstärker vorgesehen ist, bei dem die Steuerelektrode des einen Transistors (t3) durch ein Taktsignal und die Steuerelektrode des zweiten Transistors
(t4) durch eine Referenzgleichspannung ($U_{R3}$) beaufschlagt ist, und bei dem der durch das Taktsignal
gesteuerte Transistor (t3) mit seiner Stromausgangselektrode mit der Stromeingangselektrode des mit dem
Steuerbit beaufschlagten Transistors (T3) und der durch
die Referenzspannung beaufschlagte Transistor (t4) mit
seiner Stromausgangselektrode mit den Stromeingangselektroden der das Flip-Flop (FF) bildenden Transistoren
unmittelbar verbunden ist.

5. Digital/Analog-Wandler nach einem der Ansprüche 1 bis 4, dadurch gekennzeichnet, daß die verwendeten und einander gleichen Transistoren durch bipolare Transistoren, insbesondere vom npn-Typ, realisiert sind.

6. Digital/Analog-Wandler nach einem der Ansprüche 1 bis 4, dadurch gekennzeichnet, daß die verwendeten Transistoren durch einander gleiche MOS-Feldeffekttransistoren vom Anreicherungstyp gegeben sind.

FIG 1

FIG 2

FIG 3